# EUROPEAN PATENT SPECIFICATION

(11) **EP 4 478 868 B1**
(45) Date of publication and mention of the grant of the patent: **15.07.2026**
(21) Application number: 23766289.5
(22) Date of filing: 10.01.2023
(51) Int. Cl.: H10N 30/853, H03H 3/02, H03H 9/02, H03H 9/17, H10N 30/076, H10N 30/079

(54) **FILM STRUCTURE AND ELECTRONIC DEVICE**
FILMSTRUKTUR UND ELEKTRONISCHE VORRICHTUNG
STRUCTURE DE FILM ET DISPOSITIF ÉLECTRONIQUE

(30) Priority: 09.03.2022 JP 2022036575
(43) Date of publication of application: 18.12.2024
(73) Proprietor: I-PEX Piezo Solutions Inc., Ube-shi, Yamaguchi 755-0152 (JP)
(72) Inventor: KONISHI, Akio, Ube-shi, Yamaguchi 755-0152 (JP); KANAMORI, Hiroaki, Ube-shi, Yamaguchi 755-0152 (JP); IIZUKA, Takeshi, Ube-shi, Yamaguchi 755-0152 (JP)
(74) Representative: Kraus & Lederer PartGmbB
(86) International application number: PCT/JP2023/000246
(87) International publication number: WO 2023/171108

(56) References cited:
- EP-A1- 3 937 265
- WO-A1-2020/179210
- WO-A1-2022/145059
- CN-A- 113 049 128
- JP-A- 2007 037 271
- JP-A- 2007 037 271
- JP-A- 2017 201 050
- JP-A- 2018 181 870
- JP-A- 2018 181 870
- JP-A- 2019 216 181
- JP-A- 2020 184 703
- US-A1- 2019 089 325
- LIU YAN ET AL: "Materials, design, and characteristics of bulk acoustic wave resonator: A review", MICROMACHINES, vol. 11, no. 7, 28 June 2020 (2020-06-28), Switzerland, pages 630, XP093263039, ISSN: 2072-666X, DOI: 10.3390/mi11070630

## Description

### TECHNICAL FIELD

The present invention relates to a film structure and an electronic device.

### BACKGROUND ART

There has been known a film structure including a substrate and a piezoelectric film formed on the substrate, and an electronic device including the film structure.

JP2003-198319A (Patent Literature 1) discloses a technique in which a piezoelectric thin film is an aluminum nitride thin film exhibiting c-axis orientation in a thin film piezoelectric resonator including a substrate made from a semi-conductor or an insulator having a vibration space, and a laminated structure in which a lower electrode, a piezoelectric thin film, and an upper electrode are laminated in this order at a position facing the vibration space of the substrate.
JP 2007 037271 A aims to provide a piezoelectric thin-film vibrator having no warpage, a drive unit using the vibrator, and a piezoelectric motor, related to the piezoelectric thin-film vibrator comprising a piezoelectric element formed by using a thin-film formation technology, the drive unit using the the vibrator, and the piezoelectric motor. As a solution to the problem, the document describes a piezoelectric thin-film vibrator which is constituted by comprising: a thin-plate shaped resonator that generates a free-traveling wave; a first electrode formed on the surface of the resonator; a piezoelectric thin film formed on the first electrode; the piezoelectric element provided with a plurality of second electrodes formed on the piezoelectric thin film; and a stress compensation film that compensates internal stress generated in the piezoelectric element.
EP 3 937 265 A1 describes a piezoelectric film having a single crystal structure which is able to be formed, from various piezoelectric materials, on a film structure. A film structure according to the document comprises: a substrate; a buffer film which is formed on the substrate and has a tetragonal crystal structure containing zirconia; a metal film containing a platinum group element, which is formed on the buffer film by means of epitaxial growth; and a film containing Sr(Ti₁₋ₓ, Ruₓ)O₃ (wherein 0 ≤ x ≤ 1), which is formed on the metal film by means of epitaxial growth.
WO 2022/145059 A1 describes a film structure which comprises: a substrate which is an Si substrate or an SOI substrate; a buffer film which is formed on the substrate and contains ZrO2; and a piezoelectric film which is formed on the buffer film. With respect to this film structure, the polarization direction of the piezoelectric film is preferentially oriented in a direction that is parallel to the substrate.
Y. Liu et al. (Micromachines 2020, 11(7), 630) describe materials, design, and characteristics of bulk acoustic wave resonators (a review).
US 2019/0089325 A1 describes a piezoelectric material which comprises aluminum nitride (AlN) doped with ytterbium (Yb), an atomic percentage of Yb in the AlN being greater than or equal to approximately 10.0% and less than or equal to approximately 27.0%. Piezoelectric layers comprising the piezoelectric material may be used in bulk acoustic wave (BAW) acoustic resonators, and surface acoustic wave (SAW) acoustic resonators. The BAW acoustic resonators and SAW acoustic resonators can be used in a variety of applications.

### PRIOR ART DOCUMENTS

### PATENT LITERATURE

Patent Literature 1: JP2003-198319A

### NON-PATENT LITERATURE

Non-Patent Literature 1: Yukihiro Kanachika, "Technology Trend of High Heat Dissipation AlN Substrate for Semiconductor Device" Journal of The Japan Institute of Electronics Packaging, 2012, Vol. 15, No. 3, p. 185-189

### SUMMARY OF INVENTION

### PROBLEM TO BE SOLVED BY THE INVENTION

In the technique described in Patent Literature 1, the aluminum nitride film, which is a piezoelectric film, is c-axis oriented, and a polarization direction of the piezoelectric film is oriented perpendicularly to the substrate. In this way, the polarization direction of the piezoelectric film can be aligned in a direction perpendicular to the substrate. On the other hand, in order to improve a dielectric constant characteristic and a withstanding voltage characteristic, in addition to the polarization direction of the piezoelectric film being oriented perpendicular to the substrate, it may be preferable to align an orientation direction of the piezoelectric film in a direction other than the direction perpendicular to an upper surface of the substrate, for example, an in-plane direction along the upper surface of the substrate, that is, to epitaxially grow the piezoelectric film, but it is difficult to align the orientation direction of the piezoelectric film in the in-plane direction along the upper surface of the substrate. Depending on the device, an advantageous device can be created by orienting the polarization direction of the piezoelectric film perpendicularly to the substrate, as well as aligning the orientation direction of the piezoelectric film in the in-plane direction along the upper surface of the substrate.

The present invention has been made in order to solve the problems in conventional art as described above. An object of the present invention is to provide a film structure including a substrate and a piezoelectric film formed on the substrate, in which a polarization direction of the piezoelectric film is aligned in a direction perpendicular to the substrate, and an orientation direction of the piezoelectric film is also aligned in an in-plane direction along an upper surface of the substrate.

### MEANS FOR SOLVING THE PROBLEM

The film structure according to the present invention is defined in claim 1. Preferred embodiments thereof are defined in the dependent claims.

The film structure includes a metal film formed on the buffer film; the metal film is a Pt film. The film structure may include an SRO film formed on the metal film.

The piezoelectric film is made from a nitride; the nitride is AlN; the nitride is doped with Sc.

The Si substrate may be a Si(100) substrate, or the SOI layer may be made from a Si(100) film or the Si substrate may be a Si(111) substrate, or the SOI layer may be made from a Si(111) film.

An electronic device according to the present invention is an electronic device including the film structure.

The film structure may include a comb-teeth electrode formed on an upper surface or a lower surface of the piezoelectric film.

The film structure may include a matching layer formed on the substrate.

A hollow portion may be provided below the piezoelectric film.

The film structure may include an upper electrode formed above the piezoelectric film and a lower electrode formed below the piezoelectric film. An area of an overlapping portion of the upper electrode and the lower electrode may be smaller than an area of the hollow portion. An area of an overlapping portion of the upper electrode and the lower electrode may be equal to or smaller than 1/2 of an area of the hollow portion. The film structure may include a matching layer formed on the substrate.

The matching layer may be made from a material whose hardness increases with an increase in temperature. The material may be a Si compound.

### EFFECTS OF INVENTION

According to the present invention, a film structure including a substrate and a piezoelectric film formed on the substrate, in which a polarization direction of the piezoelectric film is aligned in a direction perpendicular to the substrate, and an orientation direction of the piezoelectric film is also aligned in an in-plane direction along an upper surface of the substrate, can be implemented.

### BRIEF DESCRIPTION OF DRAWINGS

FIG. 1 is a cross-sectional view of a film structure of Embodiment 1.
FIG. 2 is a cross-sectional view of the film structure of Embodiment 1.
FIG. 3 is a cross-sectional view of the film structure of Embodiment 1.
FIG. 4 is a cross-sectional view of the film structure of Embodiment 1.
FIG. 5 is a cross-sectional view of an electronic device of Embodiment 2.
FIG. 6 is a cross-sectional view of the electronic device of Embodiment 2.
FIG. 7 is a cross-sectional view of the electronic device of Embodiment 2.
FIG. 8 is a cross-sectional view of the electronic device of Embodiment 2.
FIG. 9 is a cross-sectional view of the electronic device of Embodiment 2.
FIG. 10 is a cross-sectional view of the electronic device of Embodiment 2.
FIG. 11 is a cross-sectional view of the electronic device of Embodiment 2.
FIG. 12 is a cross-sectional view of the electronic device of Embodiment 2.
FIG. 13 is a perspective view of an electronic device of Embodiment 3.
FIG. 14 is a perspective view of the electronic device of Embodiment 3.
FIG. 15 is a perspective view of the electronic device of Embodiment 3.
FIG. 16 is a diagram showing a crystal structure of c-axis oriented AlN.
FIG. 17 is a graph showing an example of an ω-2θ spectrum of a film structure in Example 1, which is obtained by an XRD method.
FIG. 18 is a graph showing an example of an ω-2θ spectrum of a film structure in Example 2, which is obtained by the XRD method.
FIG. 19 is a graph showing a result of a reciprocal lattice map measurement of the film structure in Example 1.
FIG. 20 is a graph showing a result of a reciprocal lattice map measurement of the film structure in Example 2.
FIG. 21 is a graph showing an example of an φ scan spectrum of the film structure in Example 1, which is obtained by the XRD method.
FIG. 22 is a graph showing an example of an φ scan spectrum of the film structure in Example 2, which is obtained by the XRD method.
FIG. 23A is a diagram for illustrating lattice matching between an AlN(001) plane and a Pt(100) plane in the film structure in Example 1.
FIG. 23B is a diagram for illustrating lattice matching between the AlN(001) plane and the Pt(100) plane in the film structure in Example 1.
FIG. 24A is a diagram for illustrating lattice matching between an AlN(001) plane and a Pt(111) plane in the film structure in Example 2.
FIG. 24B is a diagram for illustrating lattice matching between the AlN(001) plane and the Pt(111) plane in the film structure in Example 2.

### EMBODIMENTS FOR CARRYING OUT THE INVENTION

Hereinafter, embodiments of the present invention will be described with reference to the drawings.

In order to make the description more clear, the drawings may be schematically illustrated with respect to a width, thickness, shape, and the like of each part as compared with the embodiment, but are merely examples and do not limit the interpretation of the present invention.

In the present description and each drawing, elements same as those described above in relation to the previously shown drawings are denoted by the same reference numerals, and detailed descriptions may be omitted as appropriate.

Further, in the drawings used in the embodiments, hatching (shading) for distinguishing structures may be omitted depending on the drawing.

In the following embodiments, when a range is indicated as A to B, the range is A or more and B or less, unless otherwise specified.

### (Embodiment 1)

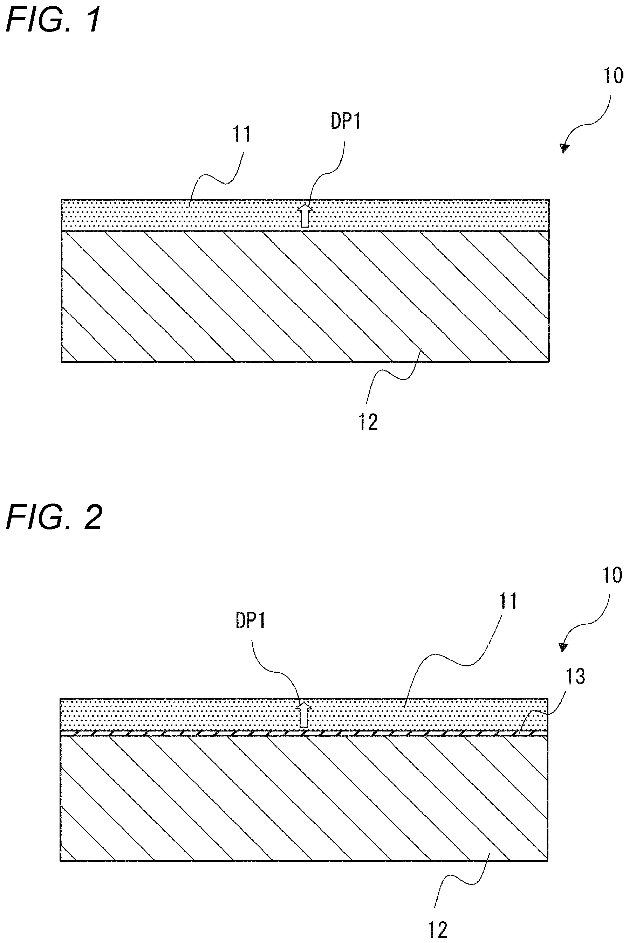

First, a film structure of Embodiment 1, which is one embodiment of the present invention, will be described. FIGS. 1 to 4 are cross-sectional views of the film structure of Embodiment 1.

As shown in FIG. 1, a film structure 10 of the present Embodiment 1 is a film structure including a piezoelectric film 11 and a substrate 12 (plus the buffer film and the Pt film as specified in claim 1, not shown in FIG. 1), in which a polarization direction of the piezoelectric film 11, that is, a piezoelectric film portion, is preferentially oriented perpendicularly to the substrate 12. In FIG. 1, the polarization direction is indicated by a polarization direction DP1 (the same applies to FIGS. 2 and 5 to 15). Since the polarization direction of the piezoelectric film 11 is preferentially oriented perpendicularly to the substrate 12, a film structure in which a polarization direction of a piezoelectric film is aligned in a direction perpendicular to a substrate can be implemented.

Alternatively, as shown in FIG. 2, the film structure 10 of the present Embodiment 1 is a film structure including the piezoelectric film 11, an electrode 13, and the substrate 12 (plus the buffer film and the Pt film as specified in claim 1, not shown in FIG. 1), in which a polarization direction of the piezoelectric film 11, that is, a piezoelectric film portion, is preferentially oriented perpendicularly to the substrate 12. As described above, since the polarization direction of the piezoelectric film 11 is preferentially oriented perpendicularly to the substrate 12, a film structure in which a polarization direction of a piezoelectric film is aligned in a direction perpendicular to a substrate can be implemented.

In the present description, the fact that the polarization direction of the piezoelectric film 11 is preferentially oriented perpendicularly to the substrate 12 means that a portion of the piezoelectric film 11 that is oriented such that the polarization direction is perpendicular to the substrate 12 exceeds 50% of the entire piezoelectric film 11, for example, in terms of volume fraction. For example, it means that when a θ-2θ spectrum is measured by an X-ray diffraction (XRD) method, in the measured θ-2θ spectrum, a peak intensity of a maximum peak indicating a portion oriented such that the polarization direction is perpendicular to the substrate 12 is higher than a peak intensity of a maximum peak indicating a portion not oriented such that the polarization direction is perpendicular to the substrate 12. The case where the polarization direction is perpendicular to the substrate 12 includes not only a case where the polarization direction is completely perpendicular to the upper surface of the substrate 12 but also a case where an angle formed by a direction perpendicular to the upper surface of the substrate 12 and the polarization direction is 20° or less.

A material of the piezoelectric film 11 is a nitride as specified in claim 1. That is, the piezoelectric film 11 is made from a nitride. The material of the piezoelectric film 11 being a nitride, aluminum nitride (AlN) as specified in claim 1, which is a lead-free material and is a piezoelectric material having excellent piezoelectric characteristics, is used.

The material of the piezoelectric film 11 is a c-axis oriented AlN-based piezoelectric material, that is, a piezoelectric material containing AlN as a main component. That is, the nitride is AlN. In the case where the material of the piezoelectric film 11 contains AlN as a main component, a piezoelectric material that is a lead-free material, has a high Clarke number, contains an element that is abundant on the earth, and has excellent piezoelectric characteristics can be used. By c-axis orientating AlN, AlN can be oriented such that a c-axis direction, which is the polarization direction of AlN, is perpendicular to the substrate 12. Note that AlN has a hexagonal wurtzite structure and is polarized in the c-axis direction. GaN also has a wurtzite structure.

In the present description, the piezoelectric material containing AlN as a main component means that a content of AlN in the piezoelectric material exceeds 50 wt% or a content of AlN in the piezoelectric material exceeds 50 mol%.

The nitride is doped with scandium (Sc). Since AlN is used as the nitride material, the piezoelectric characteristics can be improved by adding Sc to the nitride. In addition, magnesium, niobium, hafnium, yttria, boron, titanium, or the like may be used as doping material.

A polarizability of the piezoelectric film 11 is preferably 80% or more. Accordingly, a film structure in which a polarization direction of a piezoelectric film is aligned in a direction perpendicular to a substrate can be implemented.

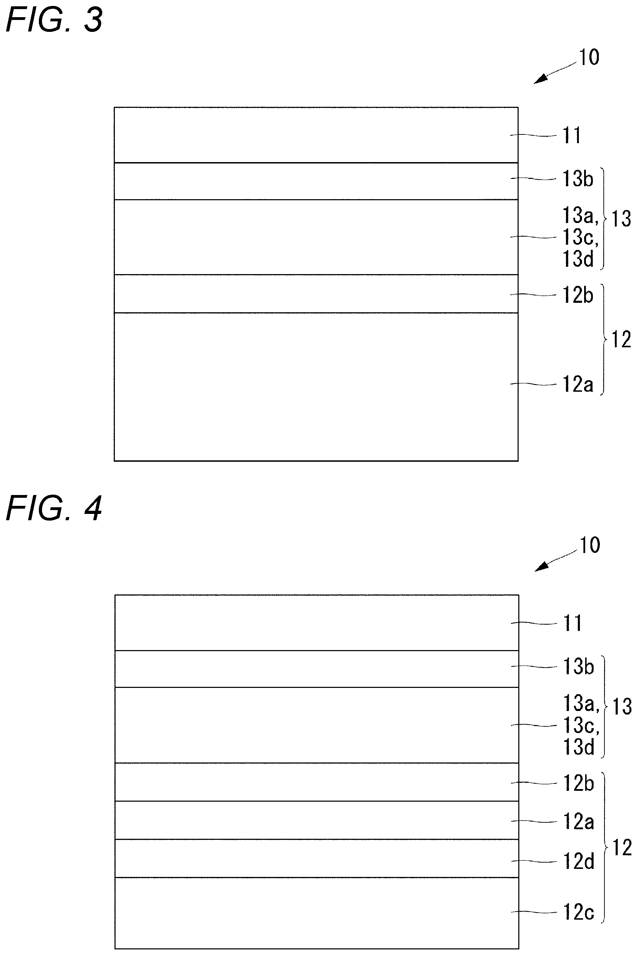

As shown in FIG. 3, the substrate 12 preferably has a structure in which a Si layer and a ZrO₂ layer are laminated in this order. Si represents silicon, and ZrO₂ represents zirconium oxide. ZrO₂ plays a role as a buffer film, and contributes to forming a piezoelectric material formed thereon with good crystallinity. That is, since the buffer film contains ZrO₂ formed on the Si layer, the polarization direction of the piezoelectric film can be aligned in the direction perpendicular to the substrate, and the orientation direction of the piezoelectric film can also be aligned in the in-plane direction along the upper surface of the substrate. The substrate 12 preferably includes a (100)-oriented Si layer 12a and a ZrO₂ layer 12b formed on the Si layer 12a. The ZrO₂ layer 12b preferably contains (200)-oriented ZrO₂ and (002)-oriented ZrO₂. As the Si layer 12a of the substrate 12, a (100)-oriented Si substrate, that is, a Si(100) substrate can be used. In such a case, the polarization direction of the piezoelectric film 11, i.e. a piezoelectric material containing a c-axis oriented AlN-based piezoelectric material as a main component, is oriented perpendicularly to the substrate 12, and the epitaxially grown piezoelectric film 11 can be easily formed on the substrate 12. A (100)-oriented Si substrate can be used as the Si layer 12a of the substrate 12, and thus an electronic device in which a polarization direction of the piezoelectric film 11 is aligned in a direction perpendicular to a substrate and an orientation direction of the piezoelectric film is also aligned in an in-plane direction along an upper surface of a substrate can be formed on an inexpensive semi-conductor substrate.

As shown in FIG. 3, the electrode 13 has a structure in which a Pt(200) layer and a SrRuO₃(100) layer are laminated in this order. Pt represents platinum, and SrRuO₃ (SRO) represents strontium ruthenium oxide. In other words, the electrode 13 preferably includes a Pt layer 13a formed on the substrate 12 and (200)-oriented and an SRO layer 13b formed on the Pt layer 13a and (100)-oriented. In such a case, the polarization direction of the piezoelectric film 11, i.e. a piezoelectric material containing a c-axis oriented AlN-based piezoelectric material as a main component, is oriented perpendicularly to the substrate 12, and the epitaxially grown piezoelectric film 11 can be easily formed on the substrate 12 with the electrode 13 serving as a lower electrode therebetween.

It is not limited to the case where the Si layer 12a is (100)-oriented, it is not limited to the case where the ZrO₂ layer 12b is (200)-oriented or (002)-oriented, it is not limited to the case where the Pt layer 13a is (200)-oriented, and it is not limited to the case where the electrode 13 includes the SRO layer 13b formed on the Pt layer 13a and (100)-oriented.

For example, the substrate 12 may include the (111)-oriented Si layer 12a and the ZrO₂ layer 12b formed on the Si layer 12a. The ZrO₂ layer 12b preferably contains, for example, (111)-oriented ZrO₂. As the Si layer 12a of the substrate 12, a (111)-oriented Si substrate, that is, a Si(111) substrate can be used. In such a case, the polarization direction of the piezoelectric film 11, i.e. a piezoelectric material containing a c-axis oriented AlN-based piezoelectric material as a main component, is oriented perpendicularly to the substrate 12, and the epitaxially grown piezoelectric film 11 can be easily formed on the substrate 12. The electrode 13 includes the Pt layer 13a formed on the substrate 12 and (111)-oriented.

The Si layer 12a of the substrate 12 can be regarded as a substrate. In such a case, the film structure 10 of the present Embodiment 1 is a film structure including the substrate (Si layer 12a) which is a Si substrate, the buffer film (ZrO₂ layer 12b) formed on the substrate (Si layer 12a) and containing ZrO₂, and the piezoelectric film 11 formed on the buffer film (ZrO₂ layer 12b) with the metal film (Pt layer 13a) therebetween, in which the polarization direction of the piezoelectric film 11 is preferentially oriented perpendicularly to the upper surface of the substrate 12. The piezoelectric film 11 is a piezoelectric film formed on Pt/ZrO₂/Si. When the electrode 13 includes the Pt layer 13a and the SRO layer 13b, that is, when the film structure 10 further includes the metal film (Pt layer 13a) on the buffer film (ZrO₂ layer 12b) and further includes the SRO film (SRO layer 13b) on the metal film (Pt layer 13a), the piezoelectric film 11 is a piezoelectric film formed on the substrate (Si layer 12a), which is a Si substrate, with the ZrO₂ film (ZrO₂ layer 12b), the Pt film (Pt layer 13a), and the SRO film (SRO layer 13b) therebetween in this order from the bottom.

As shown in FIG. 4, instead of the Si substrate, a silicon on insulator (SOI) substrate, which is a semi-conductor substrate, can be used as the Si layer 12a of the substrate 12. When the SOI substrate is used as the substrate 12, the substrate 12 includes a base 12c made from Si, a buried oxide (BOX) layer 12d as an insulating layer which is a buried oxide film formed on the base 12c, and the Si layer 12a which is a silicon on insulator (SOI) layer made from a Si film and formed on the BOX layer 12d. Accordingly, a film structure with an excellent dielectric constant characteristic and withstanding voltage characteristic of the piezoelectric film can be formed on the SOI substrate, and an electronic device including a micro electro mechanical system (MEMS) having a plurality of piezoelectric elements formed with high shape accuracy can be easily formed on the SOI substrate. When the SOI substrate is used instead of the Si substrate, an SOI layer made from a Si(100) film may be used as the (100)-oriented Si layer 12a of the substrate 12, or an SOI layer made from a Si(111) film may be used as the (111)-oriented Si layer 12a of the substrate 12.

The Si layer 12a of the substrate 12 can be regarded as a substrate. In such a case, the film structure 10 of the present Embodiment 1 is a film structure including the substrate (Si layer 12a) which is an SOI substrate, the buffer film (ZrO₂ layer 12b) formed on the substrate (Si layer 12a) and containing ZrO₂, and the piezoelectric film 11 formed on the buffer film (ZrO₂ layer 12b) with the metal film (Pt layer 13a) therebetween, in which the polarization direction of the piezoelectric film 11 is preferentially oriented perpendicularly to the upper surface of the substrate 12. The piezoelectric film 11 is a piezoelectric film formed on Pt/ZrO₂/Si of SOI. When the electrode 13 includes the Pt layer 13a and the SRO layer 13b, that is, when the film structure 10 further includes the metal film (Pt layer 13a) on the buffer film (ZrO₂ layer 12b) and further includes the SRO film (SRO layer 13b) on the metal film (Pt layer 13a), the piezoelectric film 11 is a piezoelectric film formed on the substrate (Si layer 12a), which is an SOI substrate, with the ZrO₂ film (ZrO₂ layer 12b), the Pt film (Pt layer 13a), and the SRO film (SRO layer 13b) therebetween in this order from the bottom.

The electrode 13 may also include a Mo layer 13c or a W layer 13d instead of the Pt layer 13a. In such a case, the electrode 13 includes the Mo layer 13c or the W layer 13d, and the SRO layer 13b formed on the Mo layer 13c or the W layer 13d. In such a case, the film structure 10 of the present Embodiment 1 includes the piezoelectric film 11 formed on the substrate (Si layer 12a), which is a Si substrate or an SOI substrate, with the ZrO₂ film (ZrO₂ layer 12b) and the Mo film (Mo layer 13c) or the W film (W layer 13d) therebetween in this order from the bottom. In such a case, as in the case where the electrode 13 includes the Pt layer 13a, the polarization direction of the piezoelectric film 11, i.e. a piezoelectric material containing a c-axis oriented AlN-based piezoelectric material as a main component, is oriented perpendicularly to the substrate 12, and the epitaxially grown piezoelectric film 11 can be easily formed on the substrate 12 with the electrode 13 serving as a lower electrode therebetween. In addition to the materials described above, a Ru layer or a Cu layer may be used as the material for the electrodes 13a, 13c, or 13d. These materials are generally used as electrode materials.

A film thickness of the piezoelectric film 11 is preferably 100 nm or more. When the film thickness of the piezoelectric film 11 is 100 nm or more, the film thickness of the piezoelectric film 11 can be made sufficiently larger than when the film thickness of the piezoelectric film 11 is less than 100 nm, and thus an electronic device in which a polarization direction of a piezoelectric film is aligned in a direction perpendicular to a substrate and an orientation direction of the piezoelectric film is also aligned in an in-plane direction along an upper surface of the substrate can be formed on the substrate.

### (Embodiment 2)

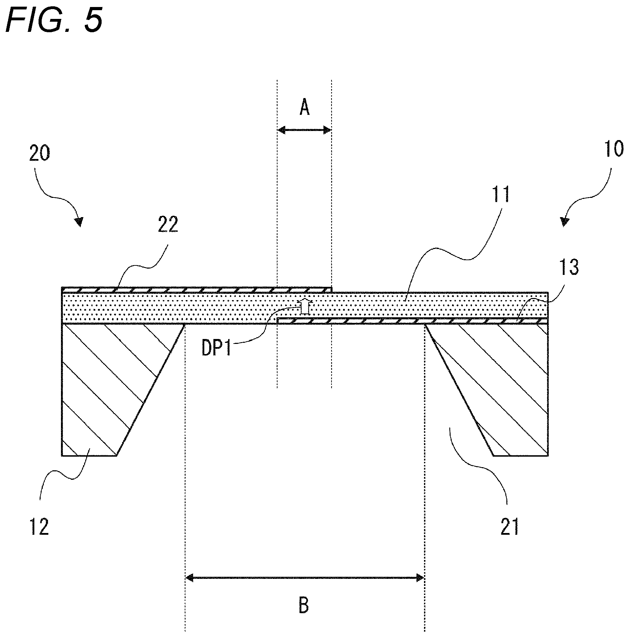

Next, an electronic device of Embodiment 2, which is one embodiment of the present invention, will be described. The electronic device of the present Embodiment 2 is a bulk acoustic wave (BAW) filter or a film bulk acoustic resonator (FBAR) including the film structure of Embodiment 1. FIGS. 5 to 12 are cross-sectional views of the electronic device of Embodiment 2.

As shown in FIG. 5, an electronic device 20 of the present Embodiment 2 is an electronic device including the film structure 10 including the piezoelectric film 11, two electrodes, and the substrate 12, in which a polarization direction of the piezoelectric film 11 is preferentially oriented perpendicularly to the substrate 12.

The film structure 10 provided in the electronic device 20 of the present Embodiment 2 may also include the piezoelectric film 11, the electrode 13, and the substrate 12, similar to the film structure 10 of Embodiment 1. That is, the electronic device 20 of the present Embodiment 2 includes the substrate 12, and the electrode 13 and the piezoelectric film 11 on the substrate 12. Therefore, for the piezoelectric film 11, the electrode 13, and the substrate 12 of the film structure 10, description of portions similar to the piezoelectric film 11, the electrode 13, and the substrate 12 of the film structure 10 of Embodiment 1 may be omitted.

On the other hand, since the electronic device 20 of the present Embodiment 2 is a BAW filter or FBAR including the film structure 10 of Embodiment 1, the substrate 12 is provided with a hollow portion, that is, a hollow portion 21 below the piezoelectric film 11. In such a case, at least a central portion of the piezoelectric film 11 located on the hollow portion 21 is not constrained by the substrate 12 and can vibrate freely, and thus a bulk acoustic wave can be easily generated in the central portion. Since the hollow portion is provided below the piezoelectric film 11, when the substrate 12 is etched from a back side, the Si layer 12a (see FIGS. 3 and 4) provided in the substrate 12 is etched and removed, but the ZrO₂ layer 12b provided in the substrate 12 (see FIGS. 3 and 4) remains unetched and can function as an etching stopper film. In FIGS. 5 to 12, illustration of the case where the ZrO₂ layer 12b (see FIGS. 3 and 4) remains without being etched is omitted.

In the film structure 10 provided in the electronic device 20 of the present Embodiment 2, an electrode 22 is provided as an upper side electrode or an upper electrode formed above the piezoelectric film 11. In such a case, the electrode 13 is an electrode as a lower side electrode or a lower electrode formed below the piezoelectric film 11. That is, the electrode 22 and the electrode 13 are an upper electrode formed above the piezoelectric film 11 and a lower electrode formed below the piezoelectric film 11, respectively. In the example shown in FIG. 5, electrodes are formed above and below the piezoelectric film 11. The film structure 10 is a film structure including the piezoelectric film 11, two electrodes, i.e., the electrode 13 and the electrode 22, and the substrate 12, in which the polarization direction of the piezoelectric film 11, that is, a piezoelectric film portion is preferentially oriented perpendicularly to the substrate 12. In such a case, by applying a voltage such as an AC voltage between the electrode 13 and the electrode 22, an electric field such as an AC electric field in a thickness direction of the piezoelectric film 11 can be easily applied to the piezoelectric film 11, and a bulk acoustic wave can be easily generated in the piezoelectric film 11. A bulk acoustic wave having a resonance frequency determined depending on an elastic characteristic of the piezoelectric film 11, or the like can be generated or passed, and thus the electronic device 20 can function as a resonator or a filter.

Also in the present Embodiment 2, as in Embodiment 1, a substrate including the (100)-oriented or (111)-oriented Si layer 12a (see FIG. 3) and the ZrO₂ layer 12b (see FIG. 3) formed on the Si layer 12a can be used as the substrate 12. The ZrO₂ layer 12b preferably contains (200)-oriented ZrO₂ and (002)-oriented ZrO₂, or (111)-oriented ZrO₂. In such a case, the Si layer 12a of the substrate 12 can be regarded as a substrate, and the electronic device 20 of the present Embodiment 2 is an electronic device including the substrate (Si layer 12a), which is a Si substrate, and the electrode 13 and the piezoelectric film 11 on the substrate, in which the polarization direction of the piezoelectric film 11 is preferentially oriented perpendicularly to the substrate 12, and the hollow portion 21 is provided below the piezoelectric film 11.

An area A of an overlapping portion of the upper and lower electrodes is preferably smaller than an area B of the piezoelectric film 11 and the lower electrode that are exposed in the hollow portion. That is, an area of the overlapping portion of the electrode 22 as an upper electrode and the electrode 13 as a lower electrode is smaller than an area of the hollow portion 21. In such a case, a portion of the piezoelectric film 11 to which the electric field in the thickness direction is applied can be reliably separated from the substrate 12 by applying a voltage between the electrode 22 and the electrode 13. Therefore, the portion of the piezoelectric film 11 to which the electric field in the thickness direction is applied is not constrained by the substrate 12 and can vibrate freely, and a bulk acoustic wave can be more easily generated.

An area ratio of the area A of the overlapping portion of the upper and lower electrodes to the area B of the piezoelectric film 11 and the lower electrode that are exposed in the hollow portion, that is, A/B is preferably less than 1/2 or 1/2 or less. That is, the area of the overlapping portion of the electrode 22 as an upper electrode and the electrode 13 as a lower electrode is 1/2 or less of the area of the hollow portion 21. In such a case, by applying a voltage between the electrode 22 and the electrode 13, the portion of the piezoelectric film 11 to which the electric field in the thickness direction is applied can be more reliably separated from the substrate 12. Therefore, the portion of the piezoelectric film 11 to which the electric field in the thickness direction is applied is not further constrained by the substrate 12 and can vibrate more freely, and a bulk acoustic wave can be more easily generated.

As described above, the film structure 10 provided in the electronic device 20 of the present Embodiment 2 may also include the piezoelectric film 11, the electrode 13, and the substrate 12, similar to the film structure 10 of Embodiment 1. Therefore, also in the film structure 10 provided in the electronic device 20 of the present Embodiment 2, as in the film structure 10 of Embodiment 1, an SOI substrate which is a semi-conductor substrate can be used instead of the Si substrate as the Si layer 12a (see FIG. 4) of the substrate 12, and the electrode 13 may also include the Mo layer 13c (see FIG. 3) or the W layer 13d (see FIG. 3) instead of the Pt layer 13a (see FIG. 3). In addition to the materials described above, a Ru layer or a Cu layer may be used as the material for the electrodes 13a, 13c, or 13d. These materials are generally used as electrode materials. Also in the film structure 10 provided in the electronic device 20 of the present Embodiment 2, as in the film structure 10 of Embodiment 1, a material of the piezoelectric film 11 is a nitride, the material of the piezoelectric film 11 is a c-axis oriented AlN-based piezoelectric material, that is, the nitride is AlN, the nitride is doped with Sc, a polarizability of the piezoelectric film 11 is preferably 80% or more, and a film thickness of the piezoelectric film is preferably 100 nm or more.

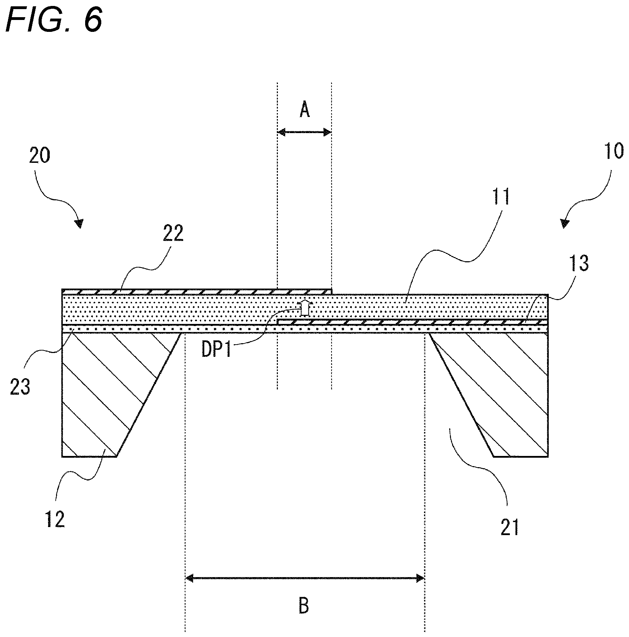

As shown in FIG. 6, it is preferable to provide a dielectric layer or a dielectric layer 23 as a matching layer between the substrate 12 and the piezoelectric film 11. That is, the electronic device 20 shown in FIG. 6 includes, in addition to the portions of the electronic device 20 shown in FIG. 5, the dielectric layer 23 as a matching layer above the substrate 12 and below the lower electrode, that is, below the electrode 13. For example, when a portion of the electronic device 20 other than the dielectric layer 23 is made from a material having a property of being softened together with an increase in temperature and the dielectric layer 23 is made from a material having a property of being hardened together with an increase in temperature, temperature dependence of a dielectric constant characteristic or piezoelectric characteristic of the electronic device 20, that is, temperature characteristics can be stabilized or adjusted.

The dielectric layer 23 is preferably a Si compound, for example, silicon dioxide (SiO₂). In such a case, the dielectric layer 23 is a dielectric layer made from a material that is highly compatible with a manufacturing process of a semi-conductor device, and thus the dielectric layer 23 can be easily formed.

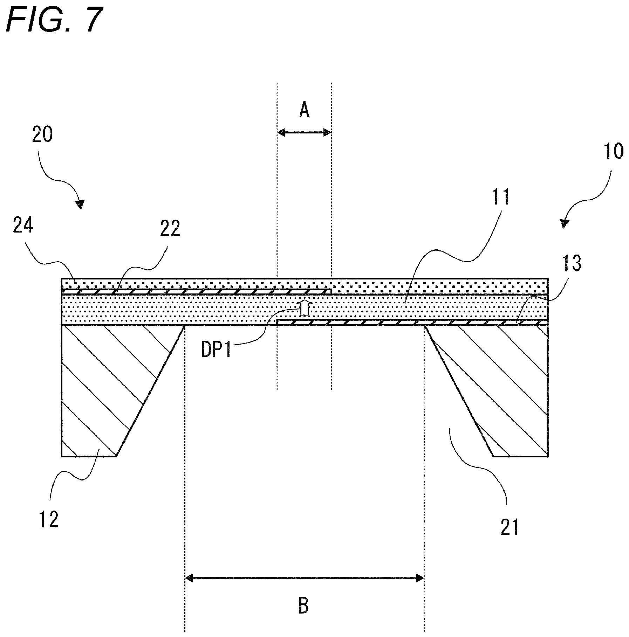

As shown in FIG. 7, it is preferable to provide a dielectric layer 24 as an upper side dielectric layer above the piezoelectric film 11. That is, the electronic device 20 shown in FIG. 7 includes, in addition to the portions of the electronic device 20 shown in FIG. 5, the dielectric layer 24 as an upper side dielectric layer above the piezoelectric film 11. For example, when a portion of the electronic device 20 other than the dielectric layer 24 is made from a material having a property of being softened together with an increase in temperature and the dielectric layer 24 is made from a material having a property of being hardened together with an increase in temperature, the temperature dependence of the dielectric constant characteristic or piezoelectric characteristic of the electronic device 20, that is, the temperature characteristics can be stabilized or adjusted.

The dielectric layer 24 is preferably a Si compound, for example, SiO₂. In such a case, the dielectric layer 24 is a dielectric layer made from a material that is highly compatible with a manufacturing process of a semi-conductor device, and thus the dielectric layer 24 can be easily formed.

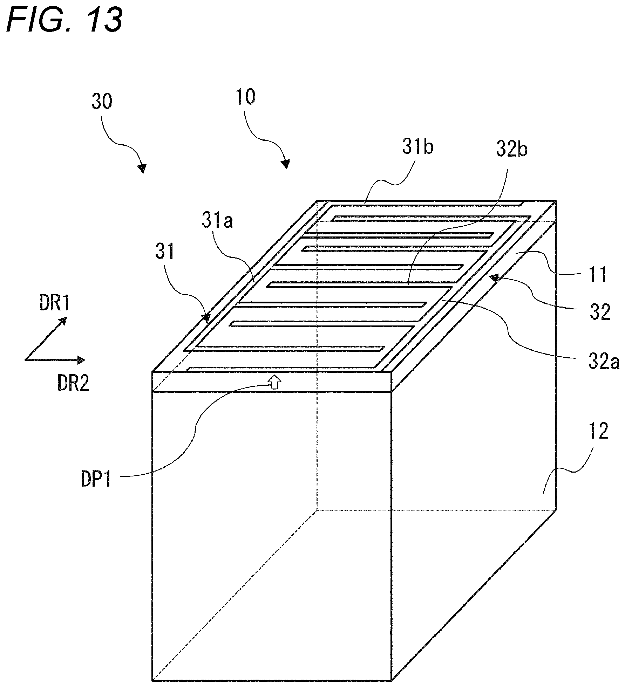

In the examples shown in FIGS. 5 to 7, for example, in the example shown in FIG. 5, either upper or lower sides of the piezoelectric film 11 may not be fixed (the same applies to Embodiment 3, which will be described later using FIGS. 13 to 15).

In the examples shown in FIGS. 5 to 7, for example, in the examples shown in FIGS. 6 and 7, either the upper or lower sides of the piezoelectric film 11 may be fixed, and an opposite side may be fixed weaker than the other with a material whose hardness changes with temperature. That is, either the upper and lower sides of the piezoelectric film 11 may be fixed, and an opposite side of the one of the upper and lower sides of the piezoelectric film 11 may be fixed weakly with a material whose hardness changes with temperature (the same applies to Embodiment 3, which will be described later using FIGS. 13 to 15). Accordingly, an electronic device that utilizes displacement in sliding direction and can compensate for temperature characteristics can be implemented.

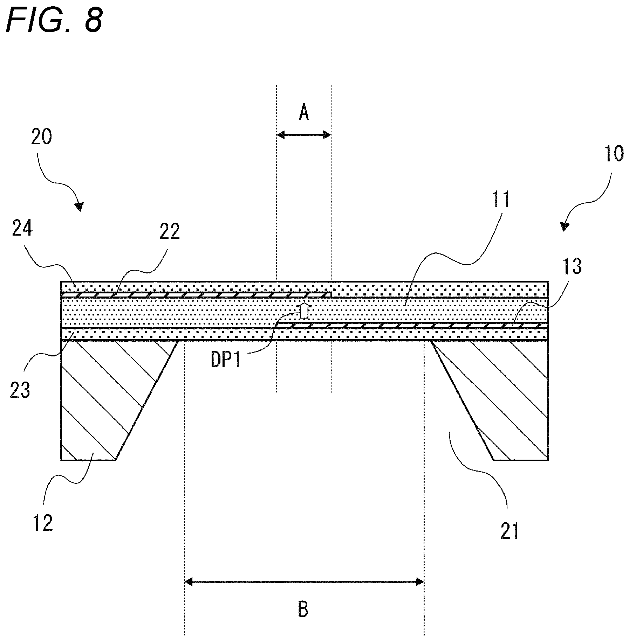

As shown in FIG. 8, it is preferable to provide the dielectric layer 23 as a lower side dielectric layer between the substrate 12 and the piezoelectric film 11 and provide the dielectric layer 24 as an upper side dielectric layer above the piezoelectric film 11. That is, the electronic device 20 shown in FIG. 8 includes, in addition to the portions of the electronic device 20 shown in FIG. 5, the dielectric layer 23 as a matching layer above the substrate 12 and below the lower electrode, that is, below the electrode 13, and the dielectric layer 24 as an upper side dielectric layer above the piezoelectric film 11. In the example shown in FIG. 8, the dielectric layer 24 is provided above the upper electrode, that is, the electrode 22. That is, also in the example shown in FIG. 8, electrodes are formed above and below the piezoelectric film 11. For example, when a portion of the electronic device 20 other than the dielectric layer 23 and the dielectric layer 24 is made from a material having a property of being softened together with an increase in temperature, and the dielectric layer 23 and the dielectric layer 24 are made from a material having a property of being hardened together with an increase in temperature (a material whose hardness increases with an increase in temperature), the temperature dependence of the dielectric constant characteristic or piezoelectric characteristic of the electronic device 20, that is, the temperature characteristics can be stabilized or adjusted. As described above, the dielectric layer 23 and the dielectric layer 24 are a Si compound, for example, SiO₂.

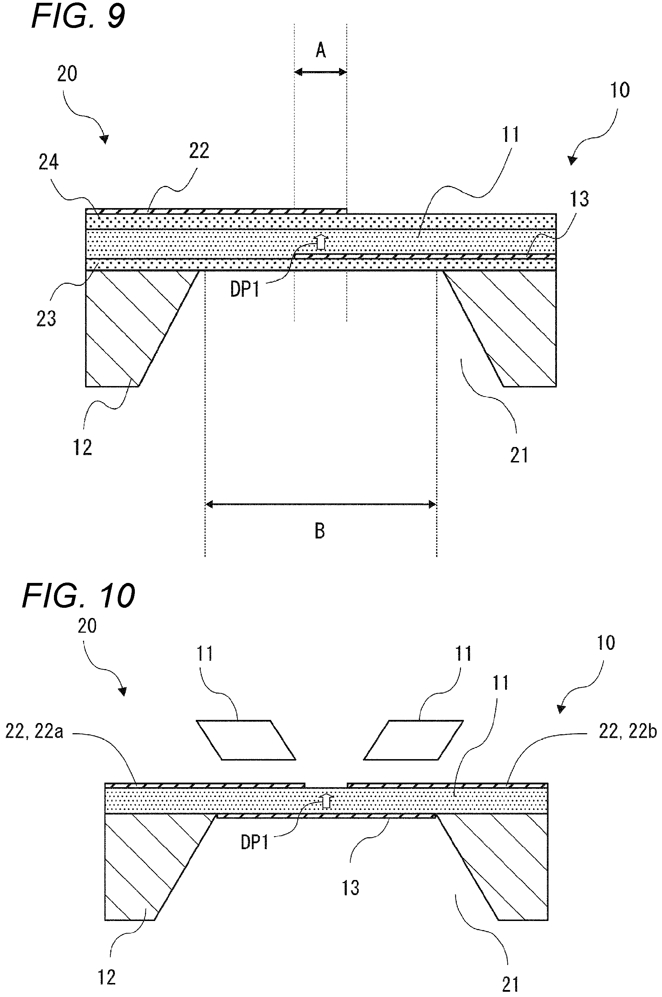

As shown in FIG. 9, it is preferable to provide the dielectric layer 23 as a lower side dielectric layer between the substrate 12 and the piezoelectric film 11, to provide the dielectric layer 24 as an upper side dielectric layer on the piezoelectric film 11, and to provide the electrode 22 as an upper side electrode on the dielectric layer 24 as an upper side dielectric layer. That is, the electronic device 20 shown in FIG. 9 is obtained by reversing a laminating order of the electrode 22 and the dielectric layer 24 in an up-down direction in the electronic device 20 shown in FIG. 8. The structure shown in FIG. 9 is not a structure in which electrodes are formed above and below the piezoelectric film 11. Even in such a case, the effect same as that of the electronic device 20 shown in FIG. 8 can be obtained. As described above, the dielectric layer 23 and the dielectric layer 24 are made of a Si compound, for example, SiO₂.

As shown in FIG. 10, it is preferable to have two or more kinds of electric field directions in a plane by providing a plurality of either the upper or lower electrode 13 or electrode 22. In the example shown in FIG. 10, the electronic device 20 includes two electrodes 22 as upper electrodes. In FIG. 10, the two electrodes 22 are shown as an electrode 22a and an electrode 22b. Accordingly, an electronic device that utilizes displacement in sliding direction can be implemented more easily. FIG. 10 schematically shows a case where the piezoelectric film 11 has two types of displacement in sliding direction.

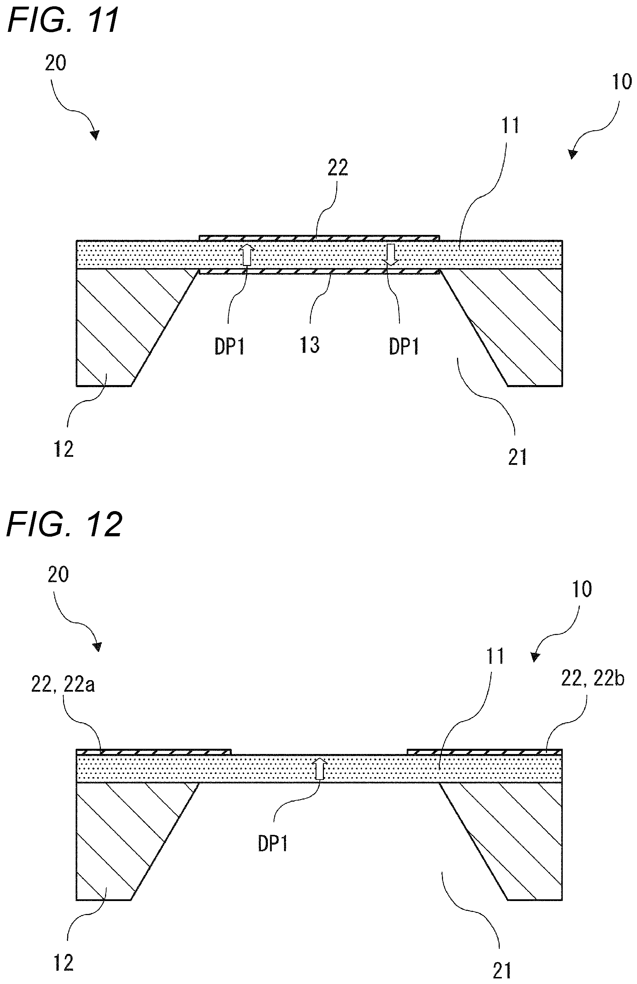

As shown in FIG. 11, it is preferable that the polarization direction (a polarization direction DP1) of the piezoelectric film 11 is preferentially oriented perpendicularly to the substrate 12 in a plurality of directions, and the electrode 22 and the electrode 13 are present on the upper portion and the lower portion of the piezoelectric body. In such a case, an electronic device that utilizes displacement in sliding direction can be implemented more easily.

As shown in FIG. 12, it is preferable that a plurality of electrodes are provided above or below the piezoelectric film 11. In the example shown in FIG. 12, the lower electrode is not provided, and two electrodes 22, that is, the electrode 22a and the electrode 22b are provided as the upper electrodes. In such a case, an electronic device that utilizes displacement in sliding direction can be implemented more easily.

### (Embodiment 3)

Next, an electronic device of Embodiment 3, which is one embodiment of the present invention, will be described. The electronic device of the present Embodiment 3 is a surface acoustic wave (SAW) filter including the film structure of Embodiment 1. FIGS. 13 to 15 are perspective views of the electronic device of Embodiment 3.

As shown in FIG. 13, an electronic device 30 of the present Embodiment 3 is an electronic device including the film structure 10 including the piezoelectric film 11, a comb-type electrode, and the substrate 12, in which a polarization direction of the piezoelectric film 11 is preferentially oriented perpendicularly to the substrate 12.

The film structure 10 provided in the electronic device 30 of the present Embodiment 3 may also include the piezoelectric film 11 and the substrate 12, similar to the film structure 10 of Embodiment 1. Therefore, for the piezoelectric film 11 and the substrate 12 of the film structure 10, description of portions similar to the piezoelectric film 11 and the substrate 12 provided in the film structure 10 of Embodiment 1 may be omitted.

On the other hand, since the electronic device 30 of the present Embodiment 3 is a SAW filter including the film structure 10 of Embodiment 1, an electrode 31 and an electrode 32 as comb-type electrodes (comb-teeth electrodes) are formed on an upper surface or a lower surface of the piezoelectric film 11, that is, a piezoelectric body portion. That is, the electronic device 30 of Embodiment 3 includes the substrate 12, and the electrode 31, the electrode 32, and the piezoelectric film 11 on the substrate 12. In such a case, a surface acoustic wave can be easily generated in the piezoelectric film 11 by applying an AC voltage between the electrode 31 and the electrode 32. A surface acoustic wave having a resonance frequency determined depending on elastic characteristics of the substrate 12, the piezoelectric film 11, the electrode 31, and the electrode 32, or the like can be generated or passed, and thus the electronic device 30 can function as a resonator or a filter.

Also in the present Embodiment 3, as in Embodiment 1, a substrate including the (100)-oriented or (111)-oriented Si layer 12a (see FIG. 3) and the ZrO₂ layer 12b (see FIG. 3) formed on the Si layer 12a can be used as the substrate 12. The ZrO₂ layer 12b preferably contains (200)-oriented ZrO₂ and (002)-oriented ZrO₂, or (111)-oriented ZrO₂. In such a case, the Si layer 12a of the substrate 12 can be regarded as a substrate, and the electronic device 30 of the present Embodiment 3 is an electronic device including the substrate (Si layer 12a), which is a Si substrate, and the piezoelectric film 11 on the substrate, in which the polarization direction of the piezoelectric film 11 is preferentially oriented perpendicularly to the substrate 12.

In the example shown in FIG. 13, the electrode 31 and the electrode 32 as comb-type electrodes are formed on the upper surface of the piezoelectric film 11. That is, in the example shown in FIG. 13, the electrode 31 and the electrode 32 are comb-teeth electrodes formed on the upper surface of the piezoelectric film 11. On the other hand, although not shown, the electrode 31 and the electrode 32 as comb-type electrodes may be formed on the lower surface of the piezoelectric film 11. That is, the electrode 31 and the electrode 32 may be comb-teeth electrodes formed on the lower surface of the piezoelectric film 11.

Since the polarization direction of the piezoelectric film 11 is preferentially oriented perpendicularly to the substrate 12, the polarization direction of the piezoelectric film 11 and a direction of the comb-type electrode preferably intersect with each other at right angles.

Here, the comb-type electrode, that is, the electrode 31 as a comb-teeth electrode includes a main body 31a extending in a direction DR1 in plan view, and a plurality of comb teeth 31b protruding from the main body 31a in a direction DR2 that intersects and preferably perpendicularly intersects with the direction DR1 in plan view, extending in the direction DR2 in plan view, and arranged in the direction DR1. The comb-type electrode, that is, the electrode 32 as a comb-teeth electrode includes a main body 32a extending in a direction DR1 in plan view, and a plurality of comb teeth 32b protruding from the main body 32a in a direction DR2 that intersects and preferably perpendicularly intersects with the direction DR1 in plan view, extending in the direction DR2 in plan view, and arranged in the direction DR1. The comb teeth 31b and the comb teeth 32b are alternately arranged along the direction DR1. In such a case, a direction of the comb-type electrode is the direction DR2 in which the comb teeth 31b and the comb teeth 32b extend, and the polarization direction DP1 of the piezoelectric film 11 is a direction that intersects and preferably perpendicularly intersects with the direction DR2 which is the direction in which the comb teeth 31b and the comb teeth 32b extend.

As described above, the film structure 10 provided in the electronic device 30 of the present Embodiment 3 may also include the piezoelectric film 11, and the substrate 12, similar to the film structure 10 of Embodiment 1. Therefore, also in the film structure 10 provided in the electronic device 30 of the present Embodiment 3, as in the film structure 10 of Embodiment 1, the substrate 12 may have a structure in which a Si layer and a ZrO₂ layer are laminated in this order, an SOI substrate which is a semi-conductor substrate may be used instead of the Si substrate as the Si layer 12a (see FIG. 4) of the substrate 12, and the electrode 13 may also include the Mo layer 13c (see FIG. 3) or the W layer 13d (see FIG. 3) instead of the Pt layer 13a (see FIG. 3). In addition to the materials described above, a Ru layer or a Cu layer may be used as the material for the electrodes 13a, 13c, or 13d. Also in the film structure 10 provided in the electronic device 30 of the present Embodiment 3, as in the film structure 10 of Embodiment 1, a material of the piezoelectric film 11 is a nitride, the material of the piezoelectric film 11 is a c-axis oriented AlN-based piezoelectric material, that is, the nitride is AlN, the nitride is doped with Sc, a polarizability of the piezoelectric film 11 is preferably 80% or more, and a film thickness of the piezoelectric film 11 is preferably 100 nm or more.

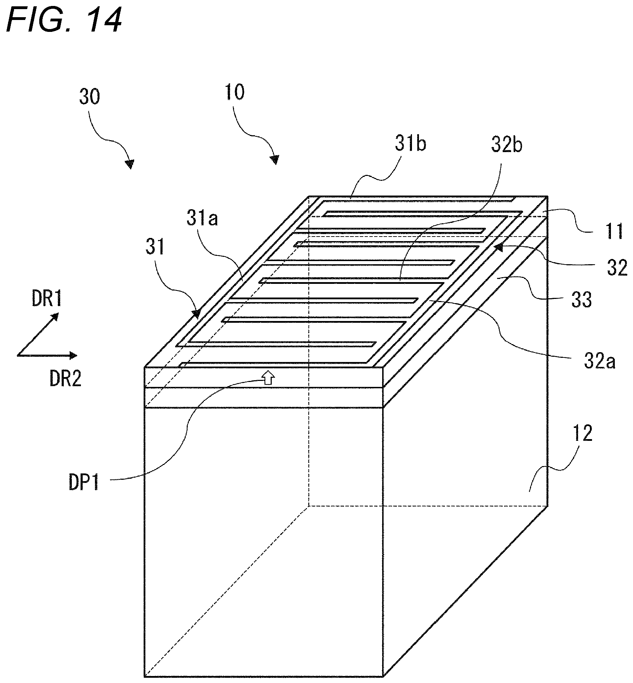

As shown in FIG. 14, it is preferable to provide a dielectric layer or a dielectric layer 33 as a matching layer between the substrate 12 and the piezoelectric film 11. That is, the electronic device 30 shown in FIG. 14 includes, in addition to the portions of the electronic device 30 shown in FIG. 13, the dielectric layer 33 as a matching layer formed above the substrate 12 and below the piezoelectric film 11. Thus, acoustic matching between the substrate 12 and the piezoelectric film 11 can be achieved. For example, when a portion of the electronic device 30 other than the dielectric layer 33 is made from a material having a property of being softened together with an increase in temperature and the dielectric layer 33 is made from a material having a property of being hardened together with an increase in temperature, the temperature dependence of the dielectric constant characteristic or piezoelectric characteristic of the electronic device 30, that is, the temperature characteristics can be stabilized or adjusted.

The dielectric layer 33 is preferably a Si compound, for example, SiO₂. In such a case, the dielectric layer 33 is a dielectric layer made from a material that is highly compatible with a manufacturing process of a semi-conductor device, and thus the dielectric layer 33 can be easily formed.

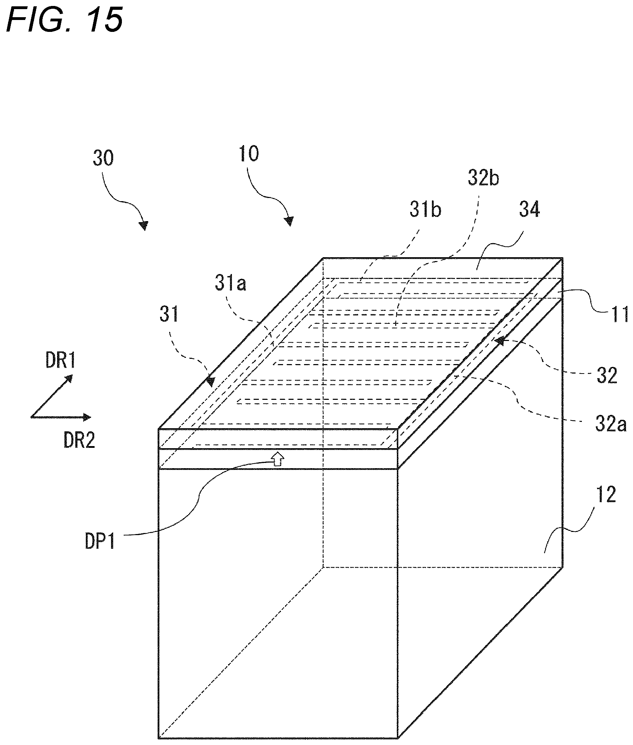

As shown in FIG. 15, it is preferable to provide a dielectric layer 34 above the piezoelectric film 11. That is, the electronic device 30 shown in FIG. 15 includes, in addition to the portions of the electronic device 30 shown in FIG. 13, the dielectric layer 34 as a matching layer above the piezoelectric film 11. Thus, acoustic matching between the substrate 12 and the piezoelectric film 11 can be achieved. For example, when a portion of the electronic device 30 other than the dielectric layer 34 is made from a material having a property of being softened together with an increase in temperature and the dielectric layer 34 is made from a material having a property of being hardened together with an increase in temperature, the temperature dependence of the dielectric constant characteristic or piezoelectric characteristic of the electronic device 30, that is, the temperature characteristics can be stabilized or adjusted.

The dielectric layer 34 is preferably a Si compound, for example, SiO₂. In such a case, the dielectric layer 34 is a dielectric layer made from a material that is highly compatible with a manufacturing process of a semi-conductor device, and thus the dielectric layer 34 can be easily formed.

### Example

Hereinafter, the present embodiment will be described in more detail based on Examples. The present invention is not limited to the following Examples.

### (Example 1 and Example 2)

Hereinafter, a test was performed in which the film structure 10 described in Embodiment 1 using FIGS. 2 and 3 was formed as a film structure in Example 1, and the piezoelectric film 11 made from c-axis oriented AlN was formed on the Si layer 12a made from a Si substrate with the ZrO₂ layer 12b and the Pt layer 13a therebetween.

### [Formation of Film Structure]

A method for forming the film structure in Example 1 will be described. First, as the Si layer 12a (see FIG. 3) made from a Si(100) substrate, a wafer made from a 15.25 cm (6-inch) silicon single crystal and having an upper surface made from a (100) plane was prepared.

Next, the ZrO₂ layer 12b (see FIG. 3) was formed on the wafer as the Si layer 12a (see FIG. 3) by electron beam evaporation. Conditions at this time are shown below.
Device: electron beam evaporation device
Pressure: 7.00 × 10⁻⁵ Pa
Evaporation source: Zr + O₂
Acceleration voltage/emission current: 7.5 kV/1.80 mA
Thickness: 60 nm
Substrate temperature: 500°C

Next, the Pt layer 13a (see FIG. 3) was formed on the ZrO₂ layer 12b (see FIG. 3) by sputtering. Conditions at this time are shown below.
Device: DC sputtering device
Pressure: 1.20 × 10⁻¹ Pa
Evaporation source: Pt
Electric power: 100 W
Thickness: 150 nm
Substrate temperature: 450°C to 600°C

Next, the piezoelectric film 11 (see FIG. 3) made from AlN was formed on the Pt layer 13a (see FIG. 3) by sputtering. Conditions at this time are shown below.
Device: AC sputtering device
Pressure: 2 Pa
Evaporation source (target): Al
Gas: Ar/N₂
Electric power: 250 W
Substrate temperature: 450°C
Thickness: 600 nm

On the other hand, a film structure in which the piezoelectric film 11 made from c-axis oriented AlN was formed on the Si layer 12a made from a Si(111) substrate, instead of the Si layer 12a made from a Si(100) substrate, with the ZrO₂ layer 12b and the Pt layer 13a therebetween was formed as a film structure in Example 2.

### [Out-of-plane Measurement]

For the film structures in Example 1 and Example 2, an ω-2θ spectrum (out-of-plane X-ray diffraction pattern) was measured by an XRD method. That is, an X-ray diffraction measurement (out-of-plane measurement) by ω-2θ scan was performed on the film structures in Example 1 and Example 2 in which the piezoelectric film 11 was already formed. The out-of-plane measurement corresponds to a case where an angle between a measurement surface and a substrate surface is less than 90°. XRD data for Example 1 and Example 2 are obtained by using an X-ray diffractometer Smart Lab manufactured by Rigaku.

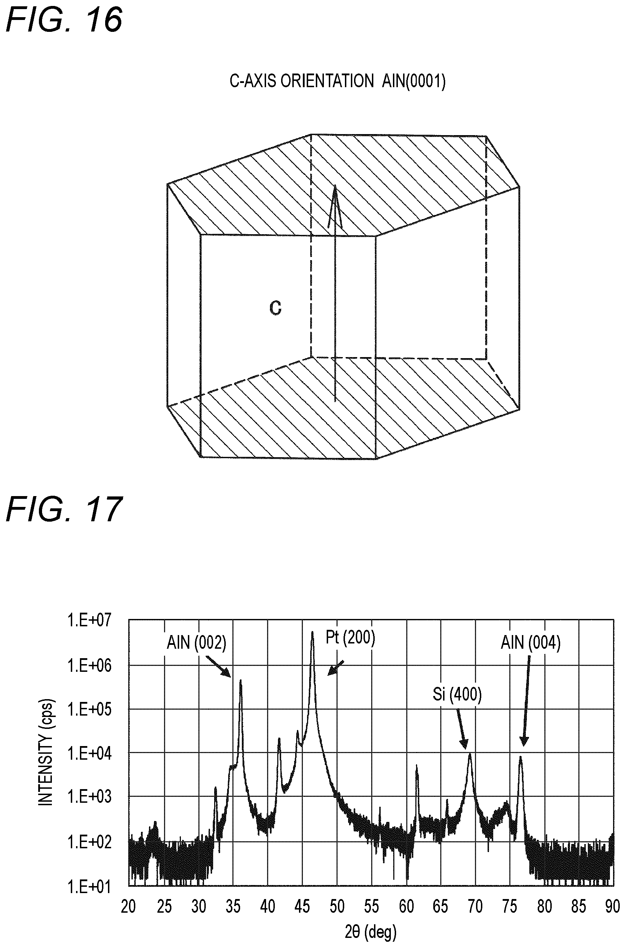

FIG. 16 shows a definition of a c-axis oriented plane. FIG. 16 is a diagram showing a crystal structure of c-axis oriented AlN. As described above, AlN has a hexagonal wurtzite structure and is polarized in a c-axis direction. In FIG. 16, a shaded portion represents a c-plane, and a c-axis represents a c(001) axis.

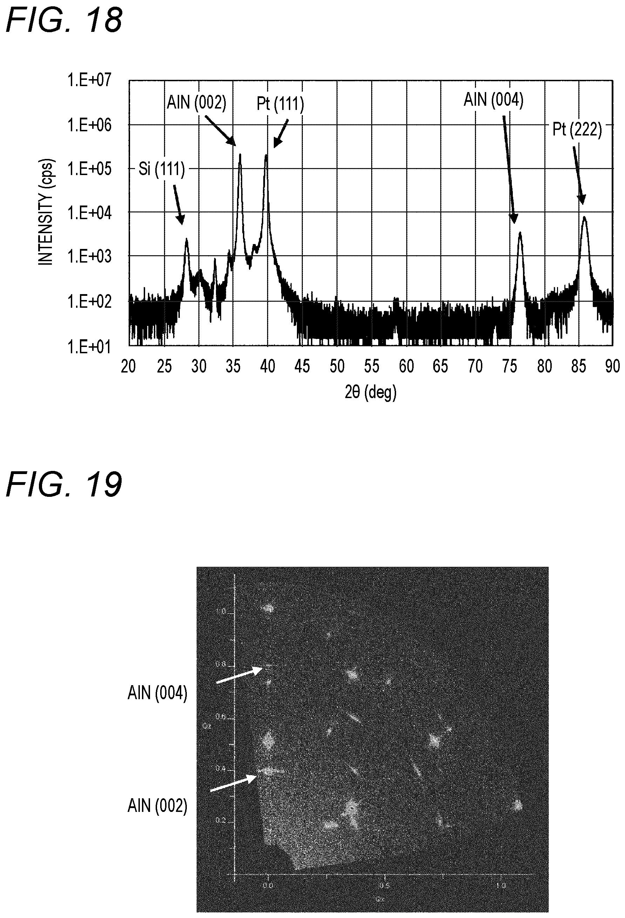

FIG. 17 is a graph showing an example of the ω-2θ spectrum of the film structure in Example 1, which is obtained by the XRD method. FIG. 18 is a graph showing an example of the ω-2 θ spectrum of the film structure in Example 2, which is obtained by the XRD method. A horizontal axis in the graphs of FIGS. 17 and 18 indicates an angle 2θ in the ω-2θ scan, and a vertical axis in the graphs of FIGS. 17 and 18 indicates an intensity of detected X-rays. FIGS. 17 and 18 show a range of 20° ≤ 2θ ≤ 90°.

In the example (Example 1) shown in FIG. 17, peaks corresponding to a (400) plane of Si, a (200) plane of Pt, and a (002) plane and (004) plane of AlN were observed in the ω-2θ spectrum. In the example (Example 2) shown in FIG. 18, peaks corresponding to a Si(111) plane, a Pt(111) plane, a Pt(222) plane, an AlN(002) plane, and an AlN(004) plane were observed in the ω-2θ spectrum.

Accordingly, it was confirmed that in the film structure in Example 1, the Pt layer 13a was (200)-oriented on the Si layer 12a made from a Si(100) substrate, and the piezoelectric film 11 made from c-axis oriented AlN was formed on the Pt layer 13a. It was confirmed that in the film structure in Example 2, the Pt layer 13a was (111)-oriented on the Si layer 12a made from a Si(111) substrate, and the piezoelectric film 11 made from c-axis oriented AlN was formed on the Pt layer 13a.

### [Reciprocal Lattice Map Measurement]

Next, the film structures in Example 1 and Example 2 were subjected to a reciprocal lattice map measurement. The reciprocal lattice map measurement is a method of three-dimensionally observing a film to be measured and confirming a fluctuation in lattice constant and an inclination of a lattice plane.

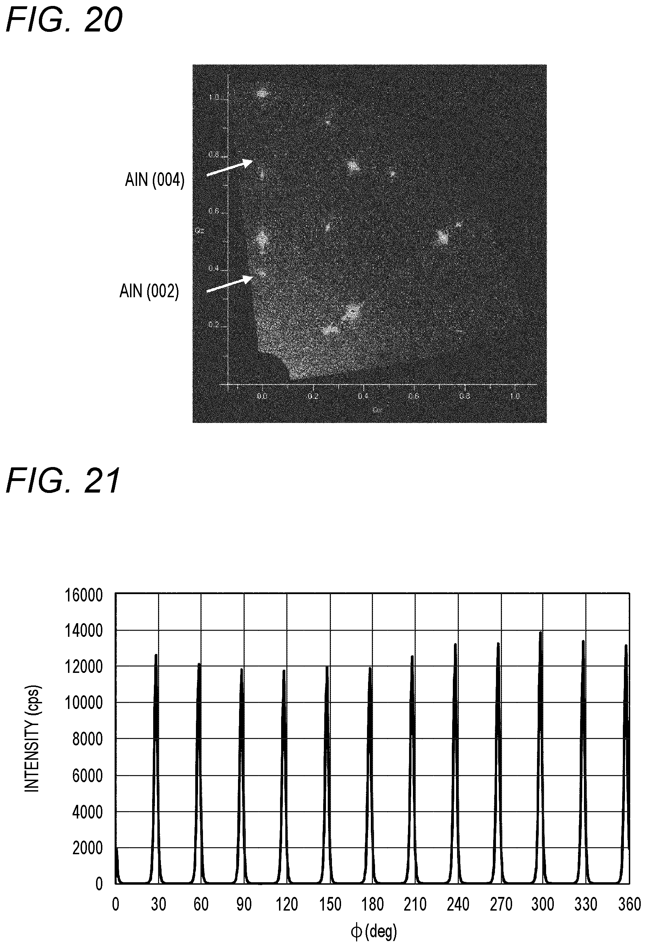

FIG. 19 is a graph showing a result of the reciprocal lattice map measurement of the film structure in Example 1. FIG. 20 is a graph showing a result of the reciprocal lattice map measurement of the film structure in Example 2. In both the example (Example 1) shown in FIG. 19 and the example (Example 2) shown in FIG. 20, peaks of AlN(002) and AlN(004) were confirmed in a vertical line, and planes were aligned. That is, in both X-ray reciprocal lattice space mapping of the film structures in Example 1 and Example 2, two reciprocal lattice points respectively representing an AlN(002) plane and an AlN(004) plane of the piezoelectric film 11 made from AlN were arranged in a Qz direction. Since the reciprocal lattice points are clear, it can be said that the fluctuation is small.

From the above results, it was found that in the film structure in Example 1, AlN was epitaxially grown with c-axis orientation on the Si layer 12a made from a Si(100) substrate. It was also found that there was no crystal fluctuation in AlN and lattice planes were aligned. That is, it was found that AlN formed on Pt(100)/ZrO₂/Si(100) was c-axis oriented and substantially single-crystallized. It was found that in the film structure in Example 2, AlN was epitaxially grown with c-axis orientation on the Si layer 12a made from a Si(111) substrate. It was also found that there was no crystal fluctuation in AlN and lattice planes were aligned. That is, it was found that AlN formed on Pt(111)/ZrO₂/Si(111) was c-axis oriented and single-crystallized.

### [In-plane Measurement]

Next, for the film structures in Example 1 and Example 2, an φ scan spectrum ((in-plane X-ray diffraction pattern) was measured by the XRD method. That is, an X-ray diffraction measurement (in-plane measurement) by an φ scan was performed on the film structures in Example 1 and Example 2 in which the piezoelectric film 11 was already formed. The in-plane measurement corresponds to a case where an angle between a measurement surface and a substrate surface is equal to 90°.

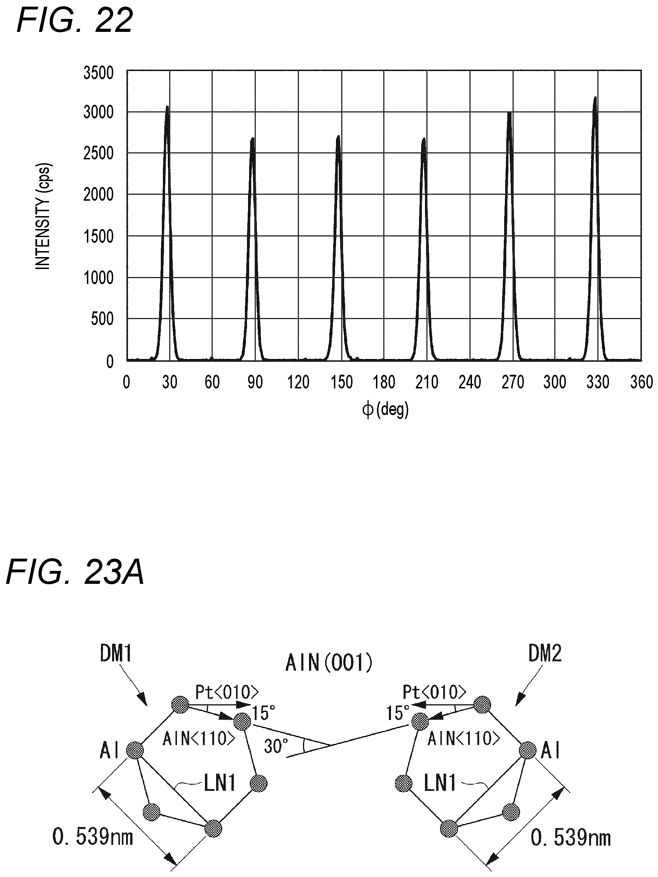

FIG. 21 is a graph showing an example of the φ scan spectrum of the film structure in Example 1, which is obtained by the XRD method. FIG. 22 is a graph showing an example of the φ scan spectrum of the film structure in Example 2, which is obtained by the XRD method. A horizontal axis in the graphs of FIGS. 21 and 22 indicates an angle φ in the φ scan, and a vertical axis in the graphs of FIGS. 21 and 22 indicates an intensity of detected X-rays. FIGS. 21 and 22 show a range of 0° ≤ φ ≤ 360°.

In the examples shown in FIGS. 21 and 22, the φ scan is performed in a state where the angle between the measurement surface and the substrate surface is around 90° (in-plane measurement), and 2θ is adjusted to be equal to an angle (59.35°) corresponding to a diffraction peak of the AlN(110) plane.

In the example (Example 1) shown in FIG. 21, in the φ scan, twelve diffraction peaks were observed that were arranged at an interval of 30° in an φ direction (horizontal axis direction) and each represented the AlN(110) plane. Therefore, it was clear that in the film structure in Example 1, the piezoelectric film 11 made from AlN was epitaxially grown on the Si layer 12a made from a Si(100) substrate with the ZrO₂ layer 12b and the Pt layer 13a therebetween. On the other hand, the crystal structure of AlN has six-fold symmetry about the c-axis. Therefore, it is considered that the piezoelectric film 11 of the film structure in Example 1 is composed of two different domains (rotational components), one of which is rotated by 30° with respect to the other within the AlN(001) plane.

In the example (Example 2) shown in FIG. 22, in the φ scan, six diffraction peaks were observed that were arranged at an interval of 60° in the φ direction (horizontal axis direction) and each represented the AlN(110) plane. Therefore, it was clear that in the film structure in Example 2, the piezoelectric film 11 made from AlN was epitaxially grown on the Si layer 12a made from a Si(111) substrate with the ZrO₂ layer 12b and the Pt layer 13a therebetween. As described above, the crystal structure of AlN has six-fold symmetry about the c-axis. Therefore, the piezoelectric film 11 of the film structure in Example 2 is considered to be composed of a single domain (rotational component).

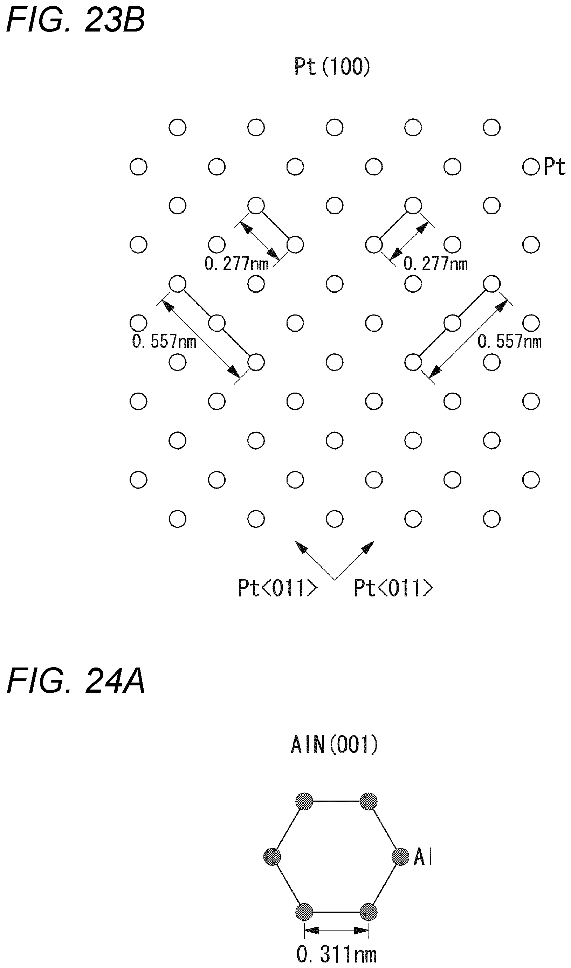

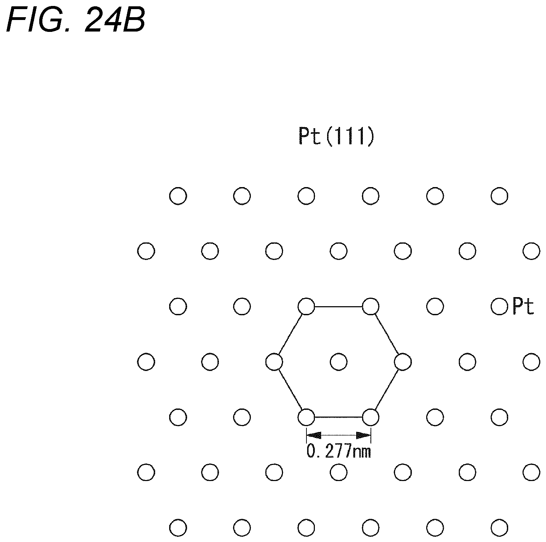

FIGS. 23A and 23B are diagrams for illustrating lattice matching between the AlN(001) plane and the Pt(100) plane in the film structure in Example 1. FIG. 23A shows a two-dimensional arrangement of Al atoms on the AlN(001) plane. FIG. 23B shows a two-dimensional arrangement of Pt atoms on the Pt(100) plane. FIGS. 24A and 24B are diagrams for illustrating lattice matching between the AlN(001) plane and the Pt(111) plane in the film structure in Example 2. FIG. 24A shows a two-dimensional arrangement of Al atoms on the AlN(001) plane. FIG. 24B shows a two-dimensional arrangement of Pt atoms on the Pt(111) plane.

In Example 1, two different rotational components of the piezoelectric film 11 are referred to as a portion DM1 and a portion DM2. As shown in FIG. 23A, when viewed from the c-axis direction, the portion DM2 is rotated counterclockwise by 30° with respect to the portion DM1. In this case, as shown in FIG. 23A, an interval between Al atoms in a direction (AlN<1-10> direction (AlN<1, -1, 0> direction or AlN <1, -1, 0, 0> direction)) along a line segment LN1 of the AlN(001) plane is 0.539 nm, and as shown in FIG. 23B, twice the interval between Pt atoms (0.277 nm) in a Pt<011> direction, which is a diagonal direction of a crystal lattice of the Pt(100) plane, is 0.557 nm, which is close to the above-described 0.539 nm.

Therefore, the portion DM1 is epitaxially grown in a state where the direction (AlN<1-10> direction) along the line segment LN1 of the AlN(001) plane is parallel to the Pt<011> direction, which is the diagonal direction of the crystal lattice of the Pt(100) plane shown in FIG. 23B, and the portion DM2 is epitaxially grown in a state where the direction (AlN<1-10> direction) along the line segment LN1 of the AlN(001) plane is parallel to the Pt<011> direction, which is the diagonal direction of the crystal lattice of the Pt(100) plane shown in FIG. 23B. The portion DM1 and the portion DM2 are present at the same ratio.

From the fact that the portion DM1 and the portion DM2 are present at the same ratio, it is considered that in the φ scan shown in FIG. 21, two pairs of six diffraction peaks each having six-fold symmetry are overlapped with being shifted by 30° from each other, whereby twelve diffraction peaks having twelve-fold symmetry are observed. Here, the portion DM1 can be a 0° rotational component, and the portion DM2 can be a 30° rotational component.

On the other hand, in Example 2, in the Pt(111) plane, Pt atoms are two-dimensionally arranged such that Pt has six-fold symmetry as shown in FIG. 24B, and a hexagonal shape formed of Pt atoms can be seen inside the Pt(111) plane. As shown in FIG. 24A, a length of one side of a hexagonal shape formed by Al atoms on the AlN(001) plane is 0.311 nm, and as shown in FIG. 24B, a length of one side of a hexagonal shape formed by six Pt atoms on the Pt(111) plane is 0.277 nm, which is close to 0.311 nm.

Therefore, the AlN film is epitaxially grown such that a hexagonal shape formed by Al atoms on the AlN(001) plane matches a hexagonal shape formed by six Pt atoms on the Pt(111) plane. Therefore, unlike Embodiment 1, Embodiment 2 does not have two rotational components but has only a single rotational component.

The above results are summarized as follows. The Si substrate serving as the Si layer 12a is a Si(100) substrate, or the SOI layer serving as the Si layer 12a is made from a Si(100) film, the electrode 13 is a Pt(100) film, and the piezoelectric film 11 is an AlN film made from AlN. In this case, preferably, the AlN film has the epitaxially grown portions DM1 and DM2, and the AlN<110> direction (AlN<1, 1, 0> direction or AlN<1, 1, -2, 0> direction) of AlN along the upper surface of the substrate in the portion DM2 is rotated clockwise or counterclockwise by 30° in plan view with respect to the AlN<110> direction of AlN along the upper surface of the substrate in the portion DM1.

More preferably, in the portion DM1, the AlN<110> direction of the AlN film along the upper surface of the substrate is rotated clockwise by 15° in plan view with respect to the Pt<010> direction of the electrode 13, which is the Pt(100) film, along the upper surface of the substrate, and in the portion DM2, the AlN<110> direction of the AlN film along the upper surface of the substrate is rotated counterclockwise by 15° in plan view with respect to the Pt<010> direction of the electrode 13, which is the Pt(100) film, along the upper surface of the substrate.

On the other hand, the Si substrate serving as the Si layer 12a is a Si(111) substrate, or the SOI layer serving as the Si layer 12a is a Si(111) film, the electrode 13 is a Pt(111) film, and the piezoelectric film 11 is an AlN film made from AlN. In this case, the epitaxial growth is preferably performed in a state where the AlN<110> direction of the AlN film along the upper surface of the substrate is parallel to the Pt<110> direction of the Pt film along the upper surface of the substrate.

Although the invention made by the present inventor has been specifically described based on the embodiments, the present invention is limited only by the appended claims.

### REFERENCE SIGNS LIST

10 film structure
11 piezoelectric film
12 substrate
12a Si layer
12b ZrO₂ layer
12c base
12d BOX layer
13 electrode
13a Pt layer
13b SRO layer
13c Mo layer
13d W layer
20, 30 electronic device
21 hollow portion
22, 22a, 22b, 31, 32 electrode
23, 24, 33, 34 dielectric layer
31a, 32a main body
31b, 32b comb teeth
DM1, DM2 portion
DP1 polarization direction
DR1, DR2 direction
LN1 line segment

## Claims

1. A film structure (10) comprising:
a substrate (12);
a buffer film containing ZrO₂ (12b) and formed on the substrate (12); and
a piezoelectric film (11), wherein
the substrate (12) is a Si substrate or a silicon on insulator, SOI, substrate including a base (12c) made from a Si substrate, an insulating layer on the base (12c), and an SOI layer made from a Si film on the insulating layer,
a polarization direction (DP1) of the piezoelectric film (11) is preferentially oriented perpendicularly to the substrate (12),
a Pt film (13a) is formed between the buffer film (12b) and the piezoelectric film (11),
the material of the piezoelectric film (11) is a c-axis oriented AlN-based material so that an orientation direction of the piezoelectric film (11) is aligned in an in-plane direction along an upper surface of the substrate (12), and
the piezoelectric film is formed on Pt/ZrO₂/Si substrate or Pt/ZrO₂/ SOI layer,
**characterized in that**
the AlN is doped with Sc.

2. The film structure (10) according to claim 1, wherein
the Si substrate (12) is a Si(100) substrate, or the SOI layer is made from a Si(100) film,
or wherein
the Si substrate (12) is a Si(111) substrate, or the SOI layer is made from a Si(111) film.

3. An electronic device (20, 30) comprising:
the film structure (10) according to any one of claims 1 or 2.

4. An electronic device (20, 30) comprising:
the film structure (10) according to claim 1, wherein
the film structure (10) includes a comb-teeth electrode (13) formed on an upper surface or a lower surface of the piezoelectric film (11).

5. The electronic device (20, 30) according to claim 4, wherein
the film structure (10) includes a matching layer formed on the substrate (12).

6. The electronic device (20, 30) according to claim 3, wherein
a hollow portion (21) is provided below the piezoelectric film (11).

7. The electronic device (20, 30) according to claim 6, wherein
the film structure (10) includes an upper electrode formed above the piezoelectric film (11) and a lower electrode formed below the piezoelectric film (11).

8. The electronic device (20, 30) according to claim 7, wherein
an area of an overlapping portion of the upper electrode and the lower electrode is smaller than an area of the hollow portion (21),
or wherein
an area of an overlapping portion of the upper electrode and the lower electrode is equal to or smaller than 1/2 of an area of the hollow portion (21).

9. The electronic device (20, 30) according to claim 6, wherein
the film structure (10) includes a matching layer formed on the substrate (12).

## Patentansprüche

1. Filmstruktur (10), umfassend:
ein Substrat (12);
einen Pufferfilm (12b), der ZrO₂ enthält und auf dem Substrat (12) ausgebildet ist; und
einen piezoelektrischen Film (11), wobei
das Substrat (12) ein Si-Substrat oder ein SOI-Substrat (Silicon on Insulator) ist, das eine Basis (12c) aus einem Si-Substrat, eine Isolierschicht auf der Basis (12c) und eine SOI-Schicht aus einem Si-Film auf der Isolierschicht umfasst,
eine Polarisationsrichtung (DP1) des piezoelektrischen Films (11) bevorzugt senkrecht zum Substrat (12) ausgerichtet ist,
ein Pt-Film (13a) zwischen dem Pufferfilm (12b) und dem piezoelektrischen Film (11) ausgebildet ist,
das Material des piezoelektrischen Films (11) ein c-achsenorientiertes Material auf AlN-Basis ist, so dass eine Orientierungsrichtung des piezoelektrischen Films (11) in einer Richtung innerhalb der Ebene entlang einer Oberseite des Substrats (12) ausgerichtet ist, und
der piezoelektrische Film auf einem Pt/ZrO₂/Si-Substrat oder einer Pt/ZrO₂/SOI-Schicht ausgebildet ist,
**dadurch gekennzeichnet, dass**
das AlN mit Sc dotiert ist.

2. Filmstruktur (10) nach Anspruch 1, wobei
das Si-Substrat (12) ein Si(100)-Substrat ist oder die SOI-Schicht aus einem Si(100)-Film besteht,
oder wobei
das Si-Substrat (12) ein Si(111)-Substrat ist oder die SOI-Schicht aus einem Si(111)-Film besteht.

3. Elektronische Vorrichtung (20, 30), umfassend:
die Filmstruktur (10) nach einem der Ansprüche 1 oder 2.

4. Elektronische Vorrichtung (20, 30), umfassend:
die Filmstruktur (10) nach Anspruch 1, wobei
die Filmstruktur (10) eine Interdigitalelektrode (13) umfasst, die auf einer Oberseite oder einer Unterseite des piezoelektrischen Films (11) ausgebildet ist.

5. Elektronische Vorrichtung (20, 30) nach Anspruch 4, wobei
die Filmstruktur (10) eine auf dem Substrat (12) ausgebildete Anpassungsschicht umfasst.

6. Elektronische Vorrichtung (20, 30) nach Anspruch 3, wobei
unterhalb des piezoelektrischen Films (11) ein Hohlraumabschnitt (21) vorgesehen ist.

7. Elektronische Vorrichtung (20, 30) nach Anspruch 6, wobei
die Filmstruktur (10) eine oberhalb des piezoelektrischen Films (11) ausgebildete obere Elektrode und eine unterhalb des piezoelektrischen Films (11) ausgebildete untere Elektrode umfasst.

8. Elektronische Vorrichtung (20, 30) nach Anspruch 7, wobei
eine Fläche eines überlappenden Abschnitts der oberen Elektrode und der unteren Elektrode kleiner ist als eine Fläche des Hohlraumabschnitts (21),
oder wobei
die Fläche eines Überlappungsabschnitts der oberen Elektrode und der unteren Elektrode gleich oder kleiner als die Hälfte der Fläche des Hohlraumabschnitts (21) ist.

9. Elektronische Vorrichtung (20, 30) nach Anspruch 6, wobei
die Filmstruktur (10) eine auf dem Substrat (12) ausgebildete Anpassungsschicht umfasst.

## Revendications

1. Structure en film (10) comprenant :
un substrat (12) ;
un film tampon contenant du ZrO₂ (12b) et formé sur le substrat (12) ; et
un film piézoélectrique (11), dans lequel
le substrat (12) est un substrat en Si ou un substrat de type « silicium sur isolant » (SOI) comprenant une base (12c) constituée d'un substrat en Si, une couche isolante sur la base (12c), et une couche SOI constituée d'un film de Si sur la couche isolante,
une direction de polarisation (DP1) du film piézoélectrique (11) est orientée préférentiellement perpendiculairement au substrat (12),
un film de Pt (13a) est formé entre le film tampon (12b) et le film piézoélectrique (11),
le matériau du film piézoélectrique (11) est un matériau à base d'AlN à orientation selon l'axe c, de sorte que la direction d'orientation du film piézoélectrique (11) est alignée dans une direction dans le plan le long d'une surface supérieure du substrat (12), et
le film piézoélectrique est formé sur un substrat Pt/ZrO₂/Si ou une couche Pt/ZrO₂/SOI,
**caractérisée en ce que**
l'AlN est dopé au Sc.

2. Structure en film (10) selon la revendication 1, dans laquelle
le substrat en Si (12) est un substrat en Si(100), ou la couche SOI est constituée d'un film de Si(100),
ou dans laquelle
le substrat en Si (12) est un substrat en Si(111), ou la couche SOI est constituée d'un film de Si(111).

3. Dispositif électronique (20, 30) comprenant :
la structure en film (10) selon la revendication 1 ou 2.

4. Dispositif électronique (20, 30) comprenant :
la structure en film (10) selon la revendication 1, dans laquelle
la structure en film (10) comprend une électrode interdigitée (13) formée sur une surface supérieure ou une surface inférieure du film piézoélectrique (11).

5. Dispositif électronique (20, 30) selon la revendication 4, dans lequel
la structure en film (10) comprend une couche d'adaptation formée sur le substrat (12).

6. Dispositif électronique (20, 30) selon la revendication 3, dans lequel
une partie creuse (21) est prévue sous le film piézoélectrique (11).

7. Dispositif électronique (20, 30) selon la revendication 6, dans lequel
la structure en film (10) comprend une électrode supérieure formée au-dessus du film piézoélectrique (11) et une électrode inférieure formée sous le film piézoélectrique (11).

8. Dispositif électronique (20, 30) selon la revendication 7, dans lequel
la surface d'une partie de chevauchement de l'électrode supérieure et de l'électrode inférieure est inférieure à la surface de la partie creuse (21),
ou dans lequel
la surface d'une partie de chevauchement de l'électrode supérieure et de l'électrode inférieure est égale ou inférieure à la moitié de la surface de la partie creuse (21).

9. Dispositif électronique (20, 30) selon la revendication 6, dans lequel
la structure en film (10) comprend une couche d'adaptation formée sur le substrat (12).
